# EUROPÄISCHE PATENTANMELDUNG

(11) **EP 4 601 139 A1**
(43) Veröffentlichungstag der Anmeldung: **13.08.2025**
(21) Anmeldenummer: 24156266.9
(22) Anmeldetag: 07.02.2024
(51) Int. Cl.: H02H 3/093, H02H 3/087, H03K 17/08

(54) **SICHERHEITSSCHALTUNG ZUM SCHUTZ EINER ZU EINEM VERBRAUCHER FÜHRENDEN ELEKTRISCHEN LEITUNG MIT TRENNSCHALTER**

(71) Anmelder: Elmos Semiconductor SE, 44227 Dortmund (DE)
(72) Erfinder: Gersemsky, Frank, 45659 Recklinghausen (DE); Fronen, Rob, 40878 Ratingen (DE)
(74) Vertreter: dompatent von Kreisler Selting Werner - Partnerschaft von Patent- und Rechtsanwälten mbB

(57) **Zusammenfassung**

Beschrieben ist eine Sicherheitsschaltung mit einem Stromerfassungsmittel (24) zur Bereitstellung eines Messsignals (I_LOAD), das die Größe eines durch die elektrische Leitung (14) und damit auch durch den Leitungspfad (18) des Trennschalters (16) fließenden Stroms repräsentiert oder aus dem sich die Größe dieses Stroms ableiten lässt und einer Auswerte- und Ansteuereinheit (22) zur Ansteuerung des Trennschalters (16) zwecks Ausschaltens seines Leitungspfads (18). Die Auswerte- und Ansteuereinheit (22) empfängt von dem Stromerfassungsmittel (24) das Messsignal und erzeugt ein Ausschaltsignal (TRIP) für den Trennschalter (16). Die Auswerte- und Ansteuerreinheit (22) weist ein erstes Tiefpassfilter (32) erster Ordnung mit einer ersten Eckfrequenz (36) und ein zweites Tiefpassfilter (34) erster Ordnung mit einer gegenüber der ersten Eckfrequenz (36) größeren zweiten Eckfrequenz (38) und einen Summierer (40) zur Addition der Ausgangssignale der beiden Tiefpassfilter (32, 34) sowie zur Ausgabe eines Summensignals und einen Komparator (42) zum Vergleichen der Größe des Summensignals mit einem Referenzwert (44) auf. Das Messsignal (I_LOAD) oder ein daraus abgeleitetes Signal wird den beiden Tiefpassfiltern (32, 34) zugeführt, wobei die Auswerte- und Ansteuereinheit (22) zuführbar ist und die Auswerte- und Ansteuereinheit (22) bei eingeschaltetem Trennschalter (16) dann, wenn das Summensignal größer als der Referenzwert (44) ist, das Ausschaltsignal (TRIP) für den Trennschalter (16) erzeugt.

## Beschreibung

Die Erfindung betrifft eine Sicherheitsschaltung zum Schutz einer zu einem Verbraucher führenden elektrischen Leitung, in der ein ein- und ausschaltbarer Leitungspfad eines ansteuerbaren Trennschalters angeordnet ist, wobei diese Sicherheitsschaltung insbesondere zur Verwendung in einem Fahrzeug vorgesehen ist.

Elektrische Verbraucher und zu diesen führende Leitungen werden typischerweise durch ein oder mehrere Sicherungen vor Schäden in Folge von Überströmen geschützt. Während man für derartige Sicherungen in früheren Jahren, unter anderem auch in der Fahrzeugindustrie, Schmelzsicherungen eingesetzt hat, geht man nicht nur in dieser Branche, sondern allgemein mehr und mehr zu Trennschaltern über, die zum Schutz des Verbrauchers automatisch ausgeschaltet werden. Als Trennschalter eignen sich beispielsweise elektromechanische Relais oder in zunehmendem Maße auch elektronische Schalter z.B. MOS-FETs oder IGBTs. Der Vorteil schaltbarer Trennschalter besteht darin, dass diese, in einem Netzwerk verbaut, nicht nur dem Schutz einzelner Netzwerkzweige oder Verbraucher, sondern auch der bedarfsweisen Umkonfiguration derartiger Leitungsnetzwerke dienen. Dies ist beispielsweise ein interessanter Anwendungsfall für den Kabelbaum eines Fahrzeugs.

Aus mehreren Gründen ist man bestrebt, die Querschnitte von elektrischen Leitungen und insbesondere von Fahrzeug-Kabelbäumen so gering wie möglich auszulegen, wobei die untere Grenze durch die geforderte Funktionstüchtigkeit der Leitungen (Stromtragfähigkeit) bestimmt ist. Die Leitungen sind also in diesen Fällen entsprechend der Nennströme auszulegen, die über die Leitungen dauerhaft fließen können müssen, ohne dass es zu Beschädigungen in Folge von beispielsweise Überhitzung wegen zu großer Ströme kommen kann. Wie die Kabel bzw. Leitungen, so sind letztendlich auch die Trennschalter vor Überströmen zu schützen. Auch sie sind demzufolge für vorgegebene Nennströme ausgelegt, die dauerhaft durch die Trennschalter fließen können, ohne dass die Trennschalter Schaden nehmen.

Aus DE 10 2020 122 571 A1 ist eine Schaltung bekannt, die im Hinblick auf die zuvor genannten Anforderungen konzipiert ist.

Aufgabe der Erfindung ist es, die Eigenschaften einer Sicherheitsschaltung zum Schutz einer zu einem Verbraucher führenden elektrischen Leitung, in der ein ein- und ausschaltbarer Leitungspfad eines ansteuerbaren Trennschalters angeordnet ist, weiter zu verbessern.

Die Lösung hierfür ist eine Sicherheitsschaltung zum Schutz einer zu einem Verbraucher führenden elektrischen Leitung, in der ein ein- und ausschaltbarer Leitungspfad eines ansteuerbaren Trennschalters angeordnet ist, insbesondere für ein Fahrzeug, mit
- einem Stromerfassungsmittel (24) zur Bereitstellung eines Messsignals, das die Größe eines durch die elektrische Leitung und damit auch durch den Leitungspfad des Trennschalters fließenden Stroms repräsentiert oder aus dem sich die Größe dieses Stroms ableiten lässt, und
- einer Auswerte- und Ansteuereinheit zur Ansteuerung des Trennschalters zwecks Ausschaltens seines Leitungspfads,
- wobei die Auswerte- und Ansteuereinheit von dem Stromerfassungsmittel das Messsignal empfängt und ein Ausschaltsignal für den Trennschalter erzeugt,
- wobei die Auswerte- und Ansteuerreinheit ein erstes Tiefpassfilter erster Ordnung mit einer ersten Eckfrequenz und ein zweites Tiefpassfilter erster Ordnung mit einer gegenüber der ersten Eckfrequenz größeren zweiten Eckfrequenz und einen Summierer zur Addition der Ausgangssignale der beiden Tiefpassfilter sowie zur Ausgabe eines Summensignals und einen Komparator zum Vergleichen der Größe des Summensignals mit einem Referenzwert aufweist und
- wobei das Messsignal oder ein aus diesem abgeleitetes Signal den beiden Tiefpassfiltern der Auswerte- und Ansteuereinheit zuführbar ist und die Auswerte- und Ansteuereinheit bei eingeschaltetem Trennschalter dann, wenn das Summensignal größer als das Referenzsignal ist, das Ausschaltsignal für den Trennschalter erzeugt.

Für das Verständnis der Erfindung sind die nachfolgend genannten Gegebenheiten und Überlegung von gewisser Bedeutung.

Typischerweise wird die zum Verbraucher führende elektrische Leitung, in der ein Trennschalter angeordnet ist, für einen niedrigeren Nennstrom ausgelegt, als der Trennschalter. Das bedeutet, dass beide gegen thermische Beschädigung bzw. Zerstörung so lange geschützt sind, wie der Strom geringer ist als der Nennstrom, für die Leitung ausgelegt ist. Der Trennschalter erleidet so lange keine thermischen Schäden oder dergleichen Beeinträchtigungen, wie der über ihn fließende Strom kleiner als der Nennstrom des Trennschalters ist. Wegen der gegenüber dem Trennschalter weitaus größeren thermischen Masse widersteht eine Leitung wesentlich länger Überströmen als dies bei dem Trennschalter der Fall ist, dessen Leitungspfad also insoweit thermisch äußerst sensibel ist.

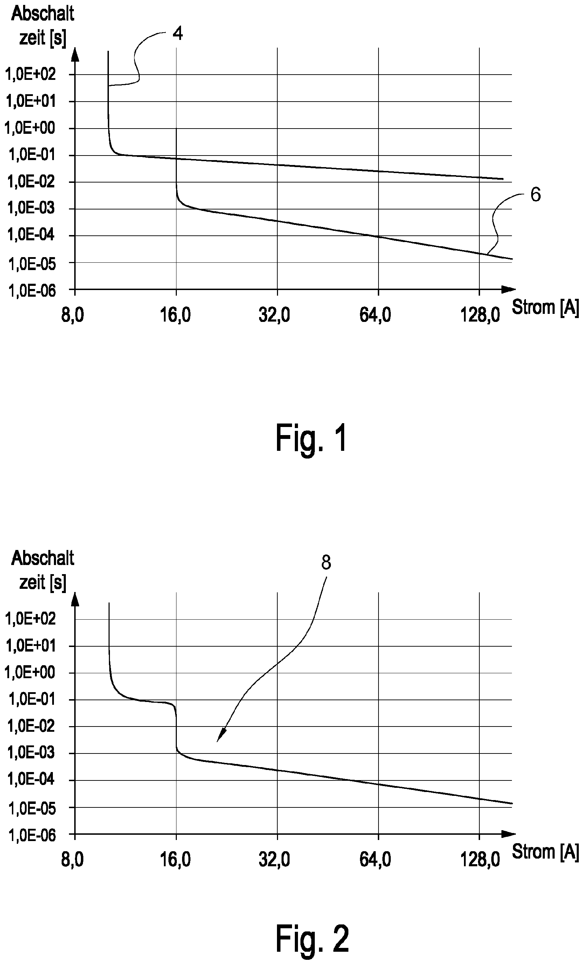

Diese Gegebenheiten sind in Fig. 1 für den Fall graphisch dargestellt, dass der Nennstrom der Leitung bei etwa 10 A liegt, während der Nennstrom für den Trennschalter bei etwa 16 A liegt. Die Kurve 4 zeigt also sozusagen das Laststromprofil bezogen auf die Abschaltzeit, d.h. die Strom/Abschaltzeit-Kennlinie, während die Kurve 6 diese Verhältnisse als Strom/Abschaltzeit-Kennlinie für den Trennschalter zeigt. Wie man erkennt, weist die Kurve 4 bei dem Nennstrom von 10 A einen im Idealfall senkrechten Anstieg auf. Bei Strömen gleich oder kleiner als 10 A kommt es also zu keinem Zeitpunkt zu einer Abschaltung. Vielmehr kommt es zu einer Abschaltung und damit zu einer Ansteuerung des Trennschalters in seinen Ausschaltzustand, wenn der Strom durch die Leitung größer als 10 A ist, und zwar in Abhängigkeit von der Dauer, für den der Überstrom fließt. Bezogen auf die Kurve 6 sind die Verhältnisse nun dergestalt, dass eine Trennung durch den Trennschalter aufgrund einer thermischen Beeinträchtigung desselben dann nicht erfolgt, wenn der Strom kleiner als der Nennstrom von in diesem Beispiel 16 A ist.

Zu erkennen ist ferner, dass die Abschaltzeit bei Strömen über einerseits dem Nennstrom der Leitung und andererseits den Nennstrom des Schalters deutlich unterschiedlich sind und auch deutlich unterschiedlich stark abfallen. Dies liegt an den unterschiedlich großen thermischen Massen von Leitung und Trennschalter. Während also beispielsweise der Trennschalter bei einem Strom von 32 A nach etwa 0,5 ms zu einer Abschaltung führen würde, würde das bezogen auf die Leitung erst nach einer Zeit von ca. 0,05 s erfolgen.

Für die Gesamtbetrachtung des Systems aus Leitung und Trennschalter ist die Überlagerung der beiden Kurven 4, 6 der Fig. 1 entscheidend, wie es in Fig. 2 gezeigt ist. Das zeitliche Abschaltverhalten bei einem Strom zwischen mehr als 10 A und bis zu 16 A wird also durch die Leitung bestimmt, während das zeitliche Abschaltverhalten oberhalb von 16 A durch den Trennschalter bestimmt wird. Anhand der Gesamt-Strom/Abschaltzeit-Kennlinie 8 ist zu erkennen, dass es bei 16 A zu einem starken Anstieg von idealerweise unendlich kommt. Fehler bei der Messung der Stromstärke der Leitung, die nie ganz ausgeschlossen werden können, können also zu ggf. schwerwiegenden Folgen führen. Eine Messungenauigkeit von wenigen Prozent kann dazu führen, dass der Trennschalter öffnet, obwohl dies nicht erforderlich ist bzw. nicht nach der laut Gesamtkurve vorgegebenen Zeit erfolgen müsste.

Hier nun setzt die Erfindung an, indem erfindungsgemäß eine Sicherheitsschaltung vorgeschlagen wird, die den starken Anstieg im Bereich des Nennstroms des Trennschalters, also die Unstetigkeit der Gesamtkennlinie 8 der Fig. 2 abmildert und insoweit "abflacht".

Dazu sieht die Erfindung vor, dass das durch ein Stromerfassungsmittel, wie z.B. einen Shunt, bereitgestellte Messignal, welches die Größe des durch die elektrische Leitung und damit auch durch den Leitungspfad des Transistors fließenden Stroms repräsentiert oder aus welchem sich die Größe dieses Stroms ableiten lässt, einer Auswerte- und Ansteuereinheit zur Ansteuerung des Transistors zwecks im Bedarfsfall erforderlichen Ausschaltens seines Leitungspfads zugeführt wird. In der Auswerte- und Ansteuereinheit wird das Messsignal einem ersten Tiefpassfilter erster Ordnung und einem zweiten Tiefpassfilter erster Ordnung zugeführt. Die beiden Tiefpassfilter weisen unterschiedliche Eckfrequenzen auf; anders ausgedrückt unterscheiden sich ihre beiden Zeitkonstanten, und zwar vorzugsweise um mindestens eine Zehnerpotenz und insbesondere um zwei oder mehr als zwei Zehnerpotenzen. Das erste Tiefpassfilter, dessen Eckfrequenz größer ist als die Eckfrequenz zweiten Tiefpassfilters, dient also sozusagen der Nachbildung der Strom/Abschaltzeit-Kennlinie 6 des Trennschalters, wohingegen das zweite Tiefpassfilter mit der kleineren Eckfrequenz der Nachbildung der Strom/Abschaltzeit-Kennlinie 4 der Leitung dient. Damit ist dem Umstand Rechnung getragen, dass der Trennschalter auf hochfrequente Änderungen des Stroms wesentlich empfindlicher reagiert, als es bei der Leitung der Fall ist, die gegenüber dem Trennschalter eine wesentlich größere thermische Masse aufweist. Die Ausgänge beider Tiefpassfilter werden erfindungsgemäß summiert und das Summensignal mit einem Referenzwert verglichen. Durch die Summation der Ausgangssignale der beiden Tiefpassfilter mit insbesondere um mindesten eine Größenordnung unterschiedlichen Eckfrequenzen ist sozusagen in der Auswerte- und Ansteuereinheit der erfindungsgemäßen Sicherheitsschaltung ein Tiefpassfilter zweiter Ordnung realisiert, was dazu führt, dass in der Gesamtlastkurve der nahezu unendlich große Anstieg im Bereich des Nennstroms des Trennschalters deutlich abgemildert ist.

Ist das Summensignal kleiner als der Referenzwert, dann befindet man sich in der Gesamtbetrachtung des Systems aus Leitung und Trennschalter im zulässigen Bereich, wohingegen der Trennschalter ausgeschaltet wird, wenn das Summensignal größer ist als der Referenzwert.

In vorteilhafter Ausgestaltung der Erfindung kann vorgesehen sein, dass in der Auswerte- und Ansteuereinheit anhand des Messsignals ein die Größe der elektrischen Leistung repräsentierendes Signal erzeugbar ist, das den beiden Tiefpassfiltern zur Bildung des Grenzlastintegrals der Anordnung aus elektrischer Leitung und Trennschalter zuführbar ist. Bei dieser Ausgestaltung der Erfindung wird also das Grenzlastintegral (auch mit I²t bezeichnet) gebildet, wie es für Betrachtungen der elektrischen Belastbarkeit von beispielsweise Leitungen und sonstigen anderen elektrischen Leitern bekannt ist. Hierzu muss das Messsignal in der Auswerte- und Ansteuereinheit quadriert werden; die Integration über der Zeit erfolgt dann jeweils in jedem der beiden Tiefpassfilter.

Es ist ferner von Vorteil, wenn das Messsignal oder ein daraus abgeleitetes Signal skalierbar ist, indem es vor der Zuführung zu den beiden Tiefpassfiltern unterschiedlich gewichtet wird, und zwar mit einem Faktor F für das erste Tiefpassfilter und mit einem Faktor von (1-F) für das zweite Tiefpassfilter, und dass der Referenzwert gleich 1 ist. Insbesondere ist der Faktor F gleich 1/k², wobei k gleich dem Verhältnis aus dem Nennstrom des Trennschalters und dem Nennstrom der elektrischen Leitung ist. Diese Skalierung bewirkt, dass die Gesamt-Strom/Abschaltzeit-Kennlinie gemäß Erfindung im Bereich des Nennstroms der Leitung mit der Strom/Abschaltzeit-Kennlinie der Leitung selbst zusammenfällt.

Wie bereits oben beschrieben, ist es zweckmäßig, wenn die Eckfrequenz des ersten Tiefpassfilters um mindestens eine Zehnerpotenz und insbesondere um bis zu zwei oder mehr als zwei Zehnerpotenzen größer ist als die Eckfrequenz des zweiten Tiefpassfilters. Mit anderen Worten sollte also die Zeitkonstante des ersten Tiefpassfilters deutlich kleiner als die Zeitkonstante des zweiten Tiefpassfilters sein.

Wie ebenfalls oben bereits angeklungen ist, ist das erste Tiefpassfilter Grenzlastintegralbetrachtungen des Trennschalters und das zweite Tiefpassfilter Grenzlastintegralbetrachtungen der Leitung zugeordnet.

Als Trennschalter eignet sich insbesondere ein elektronischer Trennschalter in Form vorzugsweise eines MOSFET-Transistors, ein Feldeffekttransistor oder ein MOS-Transistor.

Zur Lösung der obigen Aufgabe dient erfindungsgemäß ferner ein Verfahren zum Schutz einer zu einem Verbraucher führenden elektrischen Leitung, in der ein ein- und ausschaltbarer Leitungspfad eines ansteuerbaren Trennschalters angeordnet ist, insbesondere für ein Fahrzeug, wobei die Leitung für einen Nominal-oder Nennstrom ausgelegt ist, der kleiner ist als der Nominal-oder Nennstrom, für den der Trennschalter ausgelegt ist, und wobei bei dem Verfahren
- ein Messsignal bereitgestellt wird, das die Größe eines durch die elektrische Leitung und damit auch durch den Leitungspfad des Trennschalters fließenden Stroms repräsentiert oder aus dem sich die Größe dieses Stroms ableiten lässt,
- das Messsignal mittels eines Tiefpassfilters zweiter Ordnung gefiltert wird,
- die Größe des dergestalt gefilterten Messsignals mit einem Referenzwert verglichen wird und
- der Trennschalter ausgeschaltet wird, wenn das gefilterte Messsignal größer ist als der Referenzwert.

Das Tiefpassfilter zweiter Ordnung wird dabei erfindungsgemäß durch zwei Tiefpassfilter erster Ordnung mit unterschiedlichen Eckfrequenzen realisiert, denen das Messsignal zugeführt wird und deren Ausgangssignale zur Bildung des gefilterten Messsignals addiert werden und das Summensignal mit dem Referenzwert verglichen wird.

Die Erfindung wird nachfolgend anhand eines Ausführungsbeispiels und unter Bezugnahme auf die Zeichnung näher erläutert. Im Einzelnen zeigen dabei:
- Fig. 1: Kennlinien, die beispielhaft die Abschaltzeiten für einen Trennschalter bei Überstrom und die Abschaltzeiten für eine Leitung bei Überstrom jeweils separat voneinander,
- Fig. 2: die Überlagerung dieser beiden Kurven,
- Fig. 3: eine schematische Blockschaltbild-Darstellung eines Ausführungsbeispiels einer erfindungsgemäßen Sicherheitsschaltung,
- Fig. 4: ebenfalls als Blockschaltbild die für die Erfindung wesentlichen Komponenten der Auswerte- und Ansteuereinheit der Sicherheitsschaltung gemäß Ausführungsbeispiel der Erfindung und
- Fig. 5: die sich nach der Erfindung ergebende Gesamtlastkurve zur Beschreibung der Abhängigkeit der Abschaltzeit von der Stromstärke bei Verwendung der erfindungsgemäßen Sicherheitsschaltung und für das Beispiel bei Annahme eines Nennstroms von 10 A für die Leitung und von 16 A für den Trennschalter.

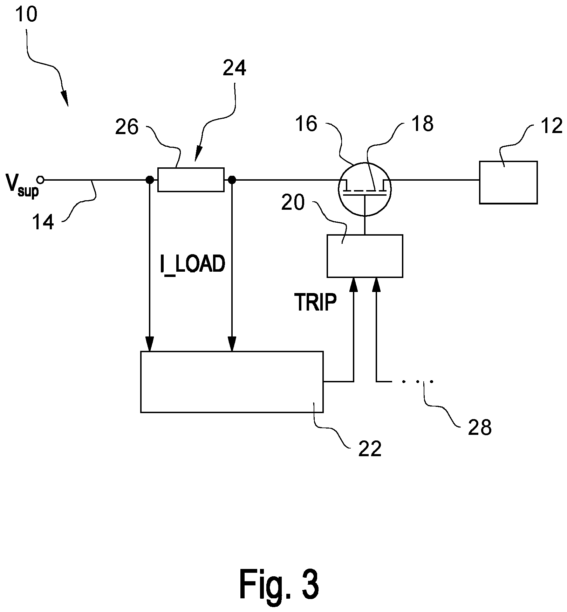

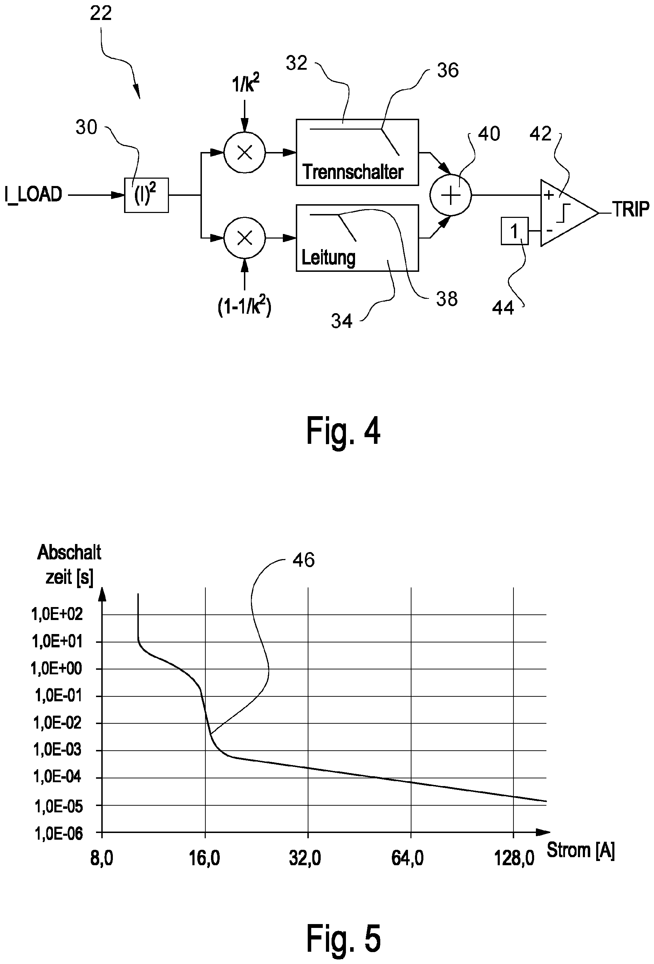

Ein erfindungsgemäßes Ausführungsbeispiel ist in den Fign. 3 und 4 gezeigt. In einem Fahrzeug-Bordnetzwerk 10 (als Beispiel für ein Netzwerk) befindet sich in einer direkt oder indirekt zu einer Last 12 führenden Leitung 14 ein elektronischer Trennschalter 16, der beispielsweise als MOSFET, also als ein Feldeffekttransistor ausgebildet ist. Alternativ kann der elektronische Trennschalter 16 auch als Bipolar-Transistor ausgeführt sein. Der Trennschalter 16 weist einen Leitungspfad 18 auf, dessen Leitfähigkeit durch eine Treiberschaltung 20 zwischen einem Minimalwert, der den Ausschaltzustand des Trennschalters 16 repräsentiert, und einem Maximalwert, der im Einschaltzustand des Trennschalters 16 gegeben ist, liegt. Mit "Einschalten" ist also das "Leitendschalten" des Trennschalters 16 gemeint, während mit "Ausschalten" das "nicht-Leitendschalten" des Leitungspfades 18 gemeint ist. Die Treiberschaltung 20 ihrerseits wird von einer Auswerte- und Ansteuereinheit 22 angesteuert, bei der es sich beispielsweise um einen Mikrokontroller mit entsprechender Peripherie wie I/O-Schnittstellen und A/D- sowie D/A-Konvertern handelt. Zusätzliche Schaltungskomponenten der Auswerte- und Ansteuereinheit 22 werden im Zusammenhang mit Fig. 4 beschrieben.

Über ein Stromerfassungsmittel 24 in Form z.B. eines Shunt-Widerstandes 26 wird die Größe des elektrischen Stroms in der Leitung 14 erfasst. Bei dem Stromerfassungsmittel 24 kann es sich auch um den Leitungspfad 18 des Trennschalters 16 handeln. Das Stromerfassungsmittel 24 kann zwischen der Stromversorgungsquelle Vₛᵤₚ und dem Trennschalter 16 oder zwischen diesem und der Last 12 (und damit im Lastpfad) angeordnet sein.

In der Auswerte- und Ansteuereinheit 22 wird typischerweise die Hauptfunktion des Trennschalters 16 realisiert, der dann, wenn die Größe des Stroms einen voreingestellten Abschaltschwellwert überschreitet, aus dem Einschaltzustand möglichst sofort in den Ausschaltzustand überführt wird.

Typischerweise befindet sich der elektronische Trennschalter 16 bereits vor dem Zuschalten der Last 12, zumindest aber zusammen mit deren Einschalten im Einschaltzustand. Der Trennschalter 16 wird hierzu von einem (nicht gezeigten und in Fig. 3 mit dem Bezugszeichen 28 angedeuteten) übergeordneten System eingeschaltet.

Von dem übergeordneten System 28 kann beispielsweise an die Treiberschaltung 20 ein Signal angelegt werden, das z.B. nach einem (aus welchen Gründen auch immer erfolgten) Ausschalten des Trennschalters 16 dafür sorgt, dass der Trennschalter 16 wieder eingeschaltet wird. Vordefinierte Reaktionen können auch in einem mit den entsprechenden Informationen versorgten Konfigurationsspeicher in der Auswerte- und Ansteuereinheit 22 oder auch außerhalb von dieser abgelegt sein. Ganz allgemein gesagt existieren für die Initiierung von Steuersignalen für den Treiber 20, die zusätzlich zu der erfindungsgemäß vorgesehenen Ansteuerung gegeben sein können, die verschiedensten Möglichkeiten. Sie können von einer übergeordneten Systemebene kommen, die das Ein- und Ausschalten der Leitung 14 bzw. des Verbrauchers 12 fordert. Das kann aber auch eine in der Auswerte- und Ansteuereinheit 22 oder an anderer Stelle vorkonfigurierte Information sein, die bestimmt, welchen Zustand der Ausgang der Auswerte- und Ansteuereinheit 22 bei bestimmten Ereignissen, z.B. nach Ablauf von vorgegebenen Zeitbedingungen oder bei Eintritt bestimmter Ereignisse, annehmen sollen, die sich aus eigenen Messmitteln oder dem Monitoring oder einem Rücksetzen ergeben (z.B. bei Überlast im Trennschalter 18, bei Unterspannung im System bzw. Bordnetz, bei Übertemperaturen z.B. des Verbrauchers oder des Trennschalters oder anderer Bauteile der erfindungsgemäßen Sicherheitsschaltung). Über diese Vorkonfiguration als auch über die höhere Systemebene können Schaltzustandsänderungen jederzeit angefordert oder geändert werden. All das jedoch ist nicht Gegenstand der Erfindung, soll aber hier als Hintergrundinformation nichtsdestotrotz erwähnt werden.

Neben der Schutzfunktion für die Last 12 sorgt die Auswerte- und Ansteuereinheit 22 erfindungsgemäß aber auch für den Schutz von Leitung 14 und Trennschalter 16 aufgrund thermischer Belastungen in Folge von Überströmen. Hierzu weist die Auswerte- und Steuereinheit 22 die in Fig. 4 schematisch gezeigten Schaltungskomponenten auf.

Das Messsignal I_LOAD wird hierzu mittels eines per Hardware oder Software realisierten Quadrierers 30 quadriert. Der Ausgang des Quadrierers 30 ist mit den Eingängen zweiter Tiefpassfilter erster Ordnung verbunden, und zwar einerseits mit einem ersten Tiefpassfilter 32 und andererseits mit einem zweiten Tiefpassfilter 34. Die beiden Tiefpassfilter weisen unterschiedliche Charakteristiken auf. So ist die Eckfrequenz (in Fig. 4 angedeutet bei 36) des ersten Tiefpassfilters 32 um mindestens eine Zehnerpotenz und vorzugsweise um zwei oder mehr Zehnerpotenzen größer als die Eckfrequenz 38 des zweiten Tiefpassfilters (in Fig. 4 angedeutet bei 38). Das erste Tiefpassfilter 32 bildet also in der Gesamt-Strom/Abschaltzeit-Kennlinie oberhalb des Nennstroms des Trennschalters 16 das Verhalten zum Schutz des Trennschalters 16 vor einer thermischen Überlastung ab, während das zweite Tiefpassfilter 34 in der Gesamt-Strom/Abschaltzeit-Kennlinie das dementsprechende Verhalten zum Schutz der Leitung 14 vor thermischer Überlast im Bereich unterhalb des Nennstroms des Trennschalters abbildet. Die beiden Tiefpassfilter 32, 34 erhalten ihre Eingangssignale durch unterschiedliche Skalierung des Ausgangssignals des Quadrierers 30. Der Skalierungsfaktor für das dem ersten Tiefpassfilter 32 zuzuführende Eingangssignal trägt beispielsweise 1/k², während dementsprechend der Skalierungsfaktor für das zweite Tiefpassfilter 34 (1-1/k²) ist.

Die Ausgangssignale beider Tiefpassfilter 32, 34 werden mittels eines Summierers 40 addiert und dem einen Eingang eines Komparators 42 zugeführt, an dessen anderem Eingang ein Referenzwert 44 von beispielhaft 1 anliegt. Der Komparator 42 erzeugt ein Ausgangssignal TRIP, wenn das Summensignal am Ausgang des Summierers 40 größer ist als der Referenzwert 44. Das Ausgangssignal TRIP führt dann vorzugsweise direkt oder nach einer Plausibilitätsbetrachtung zu einem Ausschalten des Umschalters 16.

Mit dem erfindungsgemäßen Ansatz der Verwendung zweiter Tiefpassfilter erster Ordnung, deren Ausgangssignale addiert werden und deren Eckfrequenzen ausreichend weit voneinander beabstandet sind, entsteht ein zweipoliges Filter, durch das die Unstetigkeit der Strom/Abschaltzeit-Kennlinie im Bereich um den Nominal- bzw. Nennstrom des Trennschalters 16 deutlich abgemildert wird. Aufgrund der Vermeidung dieser Unstetigkeit sinkt damit in dem Bereich um den Nennstrom des Trennschalters 16 die Abschaltzeit mit steigendem Strom kontinuierlich (siehe die Kennlinie 46 in Fig. 5) und damit nicht (mehr) sprunghaft, wie es in Fig. 2 für den Fall, dass die erfindungsgemäßen Maßnahmen nicht ergriffen werden, gezeigt ist.

### BEZUGSZEICHENLISTE

- 4: Strom/Abschaltzeit-Kennlinie (Leitung)
- 6: Strom/Abschaltzeit-Kennlinie (Trennschalter)
- 8: Gesamt-Strom/Abschaltzeit-Kennlinie
- 10: Fahrzeug-Bordnetzwerk
- 12: zu schützende Last
- 14: Leitung
- 16: Last/Verbraucher Trennschalter, Umschalter
- 18: Leitungspfad des Trennschalters
- 20: Treiberschaltung
- 22: Ansteuereinheit
- 24: Stromerfassungsmittel
- 26: Shunt-Widerstand
- 28: übergeordnetes System
- 30: Quadrierer
- 32: erstes Tiefpassfilter
- 34: zweites Tiefpassfilter
- 36: Eckfrequenz des ersten Tiefpassfilters
- 38: Eckfrequenz des zweiten Tiefpassfilters
- 40: Summierer
- 42: Komparator
- 44: Referenzwert
- 46: Gesamt-/Strom/Abschaltzeit-Kennlinie gemäß Erfindung
- I_LOAD: Messsignal
- TRIP: Abschaltsignal
- Vₛᵤₚ: Spannungsversorgungsquelle

## Patentansprüche

1. Sicherheitsschaltung zum Schutz einer zu einem Verbraucher führenden elektrischen Leitung, in der ein ein- und ausschaltbarer Leitungspfad eines ansteuerbaren Trennschalters angeordnet ist, insbesondere für ein Fahrzeug, mit
- einem Stromerfassungsmittel (24) zur Bereitstellung eines Messsignals (I_LOAD), das die Größe eines durch die elektrische Leitung (14) und damit auch durch den Leitungspfad (18) des Trennschalters (16) fließenden Stroms repräsentiert oder aus dem sich die Größe dieses Stroms ableiten lässt und
- einer Auswerte- und Ansteuereinheit (22) zur Ansteuerung des Trennschalters (16) zwecks Ausschaltens seines Leitungspfads (18),
- wobei die Auswerte- und Ansteuereinheit (22) von dem Stromerfassungsmittel (24) das Messsignal empfängt und ein Ausschaltsignal (TRIP) für den Trennschalter (16) erzeugt,
- wobei die Auswerte- und Ansteuerreinheit (22) ein erstes Tiefpassfilter (32) erster Ordnung mit einer ersten Eckfrequenz (36) und ein zweites Tiefpassfilter (34) erster Ordnung mit einer gegenüber der ersten Eckfrequenz (36) größeren zweiten Eckfrequenz (38) und einen Summierer (40) zur Addition der Ausgangssignale der beiden Tiefpassfilter (32, 34) sowie zur Ausgabe eines Summensignals und einen Komparator (42) zum Vergleichen der Größe des Summensignals mit einem Referenzwert (44) aufweist und
- wobei das Messsignal (I_LOAD) oder ein aus diesem abgeleitetes Signal den beiden Tiefpassfiltern (32, 34) der Auswerte- und Ansteuereinheit (22) zuführbar ist und die Auswerte- und Ansteuereinheit (22) bei eingeschaltetem Trennschalter (16) dann, wenn das Summensignal größer als der Referenzwert (44) ist, das Ausschaltsignal (TRIP) für den Trennschalter (16) erzeugt.

2. Sicherheitsschaltung nach Anspruch 1, **dadurch gekennzeichnet, dass** in der Auswerte- und Ansteuereinheit (22) anhand des Messsignals (I_LOAD) ein die Größe der elektrischen Leistung repräsentierendes Signal erzeugbar ist, das den beiden Tiefpassfiltern (32, 34) zur Bildung des Grenzlastintegrals der Anordnung aus elektrischer Leitung (14) und Trennschalter (16) zuführbar ist.

3. Sicherheitsschaltung nach Anspruch 1 oder 2, **dadurch gekennzeichnet, dass** das Messsignal (I_LOAD) oder ein daraus abgeleitetes Signal skalierbar ist, indem es vor der Zuführung zu den beiden Tiefpassfiltern (32, 34) unterschiedlich gewichtet wird, und zwar mit einem Faktor F für das erste Tiefpassfilter (32) und mit einem Faktor von (1-F) für das zweite Tiefpassfilter (34), und dass der Referenzwert (44) gleich 1 ist.

4. Sicherheitsschaltung nach Anspruch 3, **dadurch gekennzeichnet, dass** der Faktor F gleich 1/k² ist, wobei k gleich dem Verhältnis aus dem Nennstrom des Trennschalters (16) und dem Nennstrom der elektrischen Leitung (14) ist.

5. Sicherheitsschaltung nach einem der Ansprüche 1 bis 4, **dadurch gekennzeichnet, dass** die Eckfrequenz (36) des ersten Tiefpassfilters (32) um mindestens eine Zehnerpotenz und insbesondere um bis zu zwei oder mehr als zwei Zehnerpotenzen größer ist als die Eckfrequenz (38) des zweiten Tiefpassfilters (34).

6. Sicherheitsschaltung nach Anspruch 2 oder einem der Ansprüche 3 bis 5, sofern auf Anspruch 2 rückbezogen, **dadurch gekennzeichnet, dass** das erste Tiefpassfilter (32) Grenzlastintegralbetrachtungen des Trennschalters (16) und das zweite Tiefpassfilter (34) Grenzlastintegralbetrachtungen der Leitung (14) zugeordnet ist.

7. Sicherheitsschaltung nach Anspruch 1 bis 6, **dadurch gekennzeichnet, dass** der Trennschalter (16) als ein elektronischer Trennschalter, insbesondere als ein Feldeffekttransistor und vorzugsweise als ein MOSFET-Transistor ausgebildet ist.

8. Verfahren zum Schutz einer zu einem Verbraucher führenden elektrischen Leitung, in der ein ein- und ausschaltbarer Leitungspfad eines ansteuerbaren Trennschalters angeordnet ist, und des Trennschalters, insbesondere für ein Fahrzeug, wobei die Leitung für einen Nominal-oder Nennstrom ausgelegt ist, der kleiner ist als der Nominal-oder Nennstrom, für den der Trennschalter ausgelegt ist, und wobei bei dem Verfahren
- ein Messsignal (I_LOAD) bereitgestellt wird, das die Größe eines durch die elektrische Leitung (14) und damit auch durch den Leitungspfad (18) des Trennschalters (16) fließenden Stroms repräsentiert oder aus dem sich die Größe dieses Stroms ableiten lässt,
- das Messsignal (I_LOAD) mittels eines Tiefpassfilters (32, 34) zweiter Ordnung gefiltert wird,
- die Größe des dergestalt gefilterten Messsignals mit einem Referenzwert (44) verglichen wird und
- der Trennschalter (16) ausgeschaltet wird, wenn das gefilterte Messsignal größer ist als der Referenzwert (44).

9. Verfahren nach Anspruch 8, **dadurch gekennzeichnet, dass** das Tiefpassfilter zweiter Ordnung durch zwei Tiefpassfilter (32, 34) erster Ordnung mit unterschiedlichen Eckfrequenzen (36, 38) realisiert wird, denen das Messsignal zugeführt wird und deren Ausgangssignale zur Bildung des gefilterten Messsignals addiert werden, welches anschließend mit dem Referenzwert (44) verglichen wird.

10. Verfahren nach Anspruch 8 oder 9, zusätzlich mit den Merkmalen eines oder mehrerer der Ansprüche 1 bis 7.
